# EUROPÄISCHE PATENTSCHRIFT

(11) **EP 0 204 379 B1**
(45) Veröffentlichungstag und Bekanntmachung des Hinweises auf die Patenterteilung: **12.01.1994**
(21) Anmeldenummer: 86200966.9
(22) Anmeldetag: 03.06.1986
(51) Int. Cl.: H03H 9/10, H03H 3/02

(54) **Verfahren zum Herstellen eines hermetisch verschlossenen Bauelementengehäuses, insbesondere für Schwingquarze**
Production method for an air-tight component enclosure, in particular for a quartz resonator
Procédé de fabrication d'un boîtier hermétiquement fermé pour composants, en particulier pour résonateur en quartz

(30) Priorität: 05.06.1985 DE 3520085
(43) Veröffentlichungstag der Anmeldung: 10.12.1986
(73) Patentinhaber: Philips Patentverwaltung GmbH, 22335 Hamburg (DE); Philips Electronics N.V., 5621 BA Eindhoven (NL)
(72) Erfinder: Fick, Franz, Dipl.-Ing., D-2100 Hamburg 90 (DE)
(74) Vertreter: Kupfermann, Fritz-Joachim, Dipl.-Ing.

(56) Entgegenhaltungen:
- EP-A- 0 059 447
- FR-A- 2 461 404
- GB-A- 2 146 839
- US-A- 2 388 242
- US-A- 4 293 986

## Beschreibung

Die Erfindung betrifft ein Verfahren zum Herstellen eines hermetisch verschlossenen Bauelementengehäuses, das zur direkten Montage auf einer Leiterplatte geeignet ist, mit einem schalenförmigen Gehäuseoberteil und einem schalenförmigen Gehäuseunterteil aus einem isolierenden Material, die hermetisch miteinander verbunden werden, wobei die Zuführungsleiter zu dem Bauelement mit in die Verbindungsfuge zwischen Gehäuseoberteil und Gehäuseunterteil eingelassen werden.

Ein Verfahren dieser Art ist aus der DE-OS 34 27 646 bekannt.

Aus der US-A-42 93 986 ist ein Quarzoszillator-Gehäuse bekannt, bei dem ein Sandwich aus Gehäuseunterteil, Schwinger und Gehäuseoberteil durch auf die Kontaktflächen zwischen diesen Teilen aufgebrachte Metallschichten durch Erhitzen des gesamten Bauelements und der Bildung einer eutektischen Schmelze miteinander verbunden werden. Die Metallschicht zwischen Gehäuseunterteil und Schwinger wird mit einem Anschlußkontakt und der Metallschicht zwischen Schwinger und Gehäuseoberteil mit einem zweiten Anschlußkontakt verbunden.

Aus der US-A-23 88 242 ist es bekannt, zwei unmittelbar aufeinanderliegende Platten eines piezoelektrischen Schwingers durch eine zwischen diesen Platten aufgebrachte schleifenförmige Schicht aus leitendem Material, die durch Induktion erhitzt wird, miteinander zu verbinden. Diese Schicht dient dabei als eine Anschlußelektrode.

Schließlich ist aus der EP-A-00 59 447 ein Leiterbahngitter für Piezooszillator-Gehäuse bekannt, das geschlossene Schleifen bilden kann. Die in diesem Leiterbahngitter gebildeten Zuführungsleiter verlaufen aber nicht in der Verbindungsfläche zwischen Gehäuseoberteil und -unterteil.

Bei dem nach dem oben genannten Verfahren hergestellten Gehäuse geschieht die Verbindung der Gehäuseteile miteinander vorzugsweise durch Verkleben.

Eine sichere und stabile Verbindung der Gehäuseteile erfordert jedoch ein direktes Verschmelzen oder ein Verschmelzen mit Hilfe eines Lotes. Dazu müsste bei dem bekannten Verfahren das gesamte Gehäuse erhitzt werden, was sicher nicht ohne Schaden für das eingeschlossene Bauelement möglich ist.

Der Erfindung liegt daher die Aufgabe zugrunde, ein Verfahren der eingangs genannten Art so auszugestalten, daß die Gehäuseteile mit möglichst geringer Wärmezufuhr ohne Schaden für das eingeschlossene Bauelement direkt oder mit Hilfe eines Lotes miteinander verschmolzen werden können.

Die Erfindung geht dabei von der Erkenntnis aus, daß die zum Verschmelzen erforderliche Wärme möglichst nur am Verschmelzungsort erzeugt werden sollte.

In Anwendung dieser Erkenntnis wird die genannte Aufgabe dadurch gelöst, daß
1. die Zuführungsleiter 6 zu dem Bauelement 2 so ausgebildet werden, daß sie sich über einen Teil ihrer Länge längs zwischen den Verbindungsflächen 5 von Gehäuseoberteil 3 und Gehäuseunterteil 4 erstrecken,
2. die Gehäuseteile 3, 4 mit den dazwischenliegenden Zuführungsleitern 6 dadurch miteinander verbunden werden, daß die einzelnen, miteinander zu einem ringförmigen Leiter verbundenen Zuführungsleiter 6 in einem Hochfrequenzfeld erhitzt werden, bis die Gehäuseteile miteinander verbunden sind.

Ein solches Verfahren hat den Vorteil, daß durch das induktive Erhitzen der zwischen den Verbindungsflächen liegenden Zuführungsleiter Wärme nur unmittelbar am Verschmelzungsort zugeführt und so eine Überhitzung des Bauelementes vermieden wird.

Weitere Ausgestaltungen der Erfindung ergeben sich aus den Unteransprüchen.

Einige Ausführungsbeispiele der Erfindung werden im folgenden anhand der beigefügten Zeichnung näher erläutert.

Es zeigen:
Fig. 1 in schematischer Darstellung eine Draufsicht auf ein nach dem erfindungsgemäßen Verfahren hergestelltes Bauelementengehäuse
Fig. 2 einen Schnitt durch das Gehäuse nach Figur 1
Fig. 3 eine Draufsicht auf ein Gehäuseunterteil mit auf die Verbindungsfläche aufgelegten Zuführungsleiter gemäß einem ersten Ausführungsbeispiel
Fig. 4 eine Ansicht entsprechend Figur 3 gemäß einem zweiten Ausführungsbeispiel.

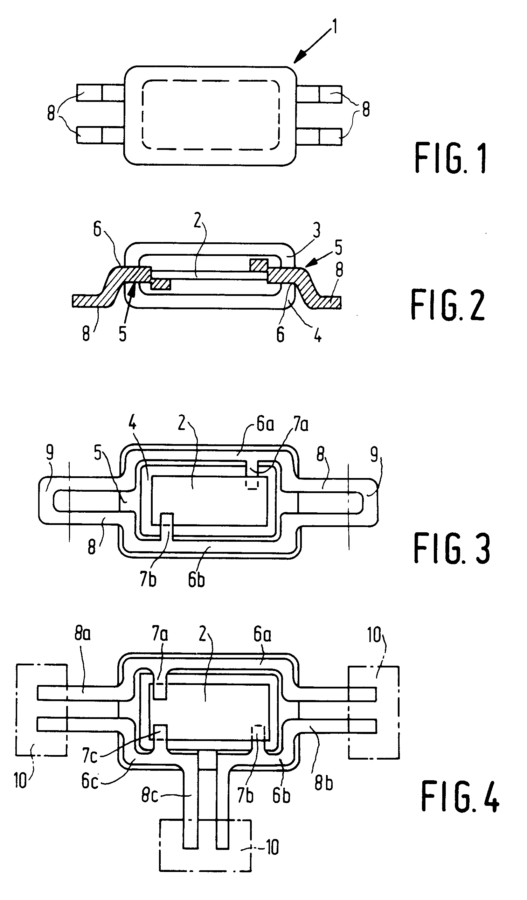

Die Figuren 1 und 2 zeigen ein nach dem erfindungsgemäßen Verfahren hergestelltes Bauelementengehäuse 1 in Draufsicht und im Längsschnitt (Figur 2). Dieses Gehäuse besteht aus einem schalenförmigen Gehäuseoberteil 3 und einem schalenförmigen Gehäuseunterteil 4 aus Glas, die hermetisch miteinander verbunden sind, wobei die Zuführungsleiter 8 zu dem in dem Gehäuse angeordneten Bauelement 2 mit in die Verbindungsfuge zwischen Gehäuseoberteil und Gehäuseunterteil eingelassen sind.
Ein solches Bauelementengehäuse 1, bei dem die Anschlußleiter 8 auf geeignete Weise geformt, z.B. wie in den Figuren 1 und 2 dargestellt, nach unten abgewinkelt sind, läßt sich leicht mit Hilfe von automatischen Bestückungsmaschinen auf Printplatten aufsetzen und mit deren Leiterbahnen verlöten.

Die Figuren 3 und 4 erläutern die Herstellung eines solchen Bauelementengehäuses mit zweimal 2, bzw. dreimal 2 Anschlußleitern.

Die Figur 3 zeigt ein Gehäuseunterteil 4 das schalenförmig ausgebildet ist und dessen Rand als Verbindungsfläche 5 zu dem entsprechend ausgebildeten Gehäuseoberteil dient. Auf die Verbindungsfläche 5 des Gehäuseunterteils 4 sind die Zuführungsleiter 6 zu dem im Gehäuse angeordneten Bauelement 2 so angeordnet, daß sie einen zu -sammenhängenden ringförmigen Leiter bilden, der sich über den größten Teil der Verbindungsfläche 5 erstreckt.
Im einzelnen besteht dieser ringförmige Leiter aus Teilen 6a und 6b, die sich über die Verbindungsfläche erstrecken und von denen Kontaktzungen 7a und 7b ausgehen, mit denen das Bauelement 2 entweder über Verbindungsdrähte oder wie in der Figur gezeigt, direkt verbunden ist, aus den Enden 8 der Zuführungsleiter, die sich außerhalb des Gehäuses erstrecken und Verbindungen 9, die nebeneinanderliegende Enden 8 der Zuführungsleiter miteinander verbinden.
Das gesamte aus den Teilen 6 bis 9 bestehende Leitergebilde wird in einem Stück aus einem geeigneten, temperaturbeständigen und hinreichend gut leitendem Material, wie z.B. Kovar hergestellt, auf das Gehäuseunterteil aufgelegt und das in das Gehäuseunterteil 4 eingebrachte Bauelement 2 mit den Kontaktzungen 7 verbunden.
Das Gebilde hat dann die in Figur 3 dargestellte Form. Jetzt wird das Gehäuseoberteil 3 mit seiner Verbindungsfläche 5, das Gehäuseunterteil mit dem daraufliegenden ringförmigen Leitergebilde aufgelegt und angepreßt.

Das ganze wird dann in ein Hochfrequenzfeld eingebracht, welches das ringförmige Leitergebilde 6 bis 9 auf eine solche Temperatur erhitzt, daß Gehäuseoberteil 3 und Gehäuseunterteil 4 unter Einschluß der Verbindungsleiter 6 miteinander verschmelzen.
Dazu wird es erforderlich sein, die Breite der Leiterteile 6a und 6b in bezug auf die Breite der Verbindungsfläche 5 geeignet zu wählen.

Obwohl in Figur 2 die Dicke der Leiter 6 bis 8 der Deutlichkeit halber übertrieben groß dargestellt ist, kann es doch erforderlich sein, den Verbindungsflächen 5 von Gehäuseunterteil und Gehäuseoberteil eine solche Form zu geben, daß beim Zusammenfügen des Gebildes aus Gehäuseunterteil 4, Gehäuseoberteil 3 und Zuführungsleitern 6 bis 9 alle Teile fugenlos aneinander anschließen.

Weiter kann es zweckmäßig sein, die Verbindungsflächen 5 und/oder die Leiterteile 6 vor dem Zusammenfügen mit einem geeigneten Material mit niedrigem Schmelzpunkt, so z.B. einem Glaslot, zu bedecken. Dann braucht das ringförmige Leitergebilde 6 bis 9 im Hochfrequenzfeld nicht so hoch erhitzt zu werden, daß das Material der Gehäuseteile plastisch wird und sich miteinander verbindet, sondern nur so hoch, daß das Lotmaterial flüssig wird.

Das Erhitzen und Verschließen wird vorzugsweise in einer inerten Atmosphäre oder im Vakuum ausgeführt um sowohl ein Oxidieren des Leitermaterials während des Erhitzens zu verhindern, als auch um im hermetisch verschlossenen Gehäuse eine dem Bauelement 2 zuträgliche Umgebung sicherzustellen.
Anschließend werden die die benachbarten Enden 8 der Zuführungsleiter verbindenden Leiterteile 9 abgetrennt und die Enden der Zuführungsleiter geeignet geformt, so daß sich das in den Figuren 1 und 2 dargestellte Bauelementengehäuse ergibt.

Das Ausführungsbeispiel nach Figur 4 entspricht weitgehend dem nach Figur 3; das Bauelement 2 ist jedoch mit 3 Anschlüssen versehen.
Entsprechend ist das ringförmige Leitergebilde dreiteilig, d.h. es sind drei auf der Verbindungsfläche 5 liegende Teile 6a, 6b und 6c der Zuführungsleiter, drei Kontaktzungen 7a, 7b und 7c sowie zweimal 3 Enden 8a, 8b und 8c der Zuführungsleiter vorgesehen.

Weiter sind die Zuführungsleiter nicht wie bei dem Ausführungsbeispiel nach Figur 3 in einem Stück hergestellt, sondern in drei Teilen 6a bis 8a, wie 6b bis 8b und 6c bis 8c, die erst dann, wenn die Zusammenstellung aus Gehäuseunterteil 4, Gehäuseoberteil 3, Bauelement 2 und Zuführungsleitern 6 bis 8 in das Hochfrequenzfeld eingebracht werden, durch Kontaktbrücken 10, die in der Figur gestrichelt dargestellt sind, miteinander verbunden werden. Diese Kontaktbrücken 10 können mechanische Kontakte sein, die solange in dem Hochfrequenzfeld eine geschlossene Leiterschleife gebildet werden sollen, auf jeweils zwei benachbarte Enden 8 der Zuführungsleiter aufgepreßt werden und diese miteinander verbinden.

Die Zahl der Zuführungsleiter kann sowohl bei dem Verfahren nach Figur 3 als auch bei dem nach Figur 4 erhöht, also ein Bauelement mit mehr als zweimal 3 Zuführungsleitern hergestellt werden.

Das hier beschriebene Verfahren eignet sich insbesondere zur Herstellung von hermetisch verschlossenen Gehäusen für einzelne Schwingquarze bzw. Quarzfilter.
Die Gehäuseteile bestehen dann vorzugsweise auch aus Glas. Die Gehäuseteile können jedoch auch aus einem keramischen Material bestehen und werden dann mit Hilfe eines Lotes miteinander und mit den Teilen 6 der Zuführungsleiter verschmolzen.

## Patentansprüche

1. Verfahren zum Herstellen eines hermetisch verschlossenen Bauelementengehäuses, das zur direkten Montage auf einer Leiterplatte geeignet ist, mit einem schalenförmigen Gehäuseoberteil und einem schalenförmigen Gehäuseunterteil aus einem isolierenden, schmelzbaren Material, die hermetisch miteinander verbunden werden, wobei die Zuführungsleiter zu dem Bauelement mit in die Verbindungsfuge zwischen Gehäuseoberteil und Gehäuseunterteil eingeschlossen werden,
dadurch gekennzeichnet,
daß
1. die Zuführungsleiter (6) zu dem Bauelement (2) so ausgebildet werden, daß sie sich über einen Teil ihrer Länge längs zwischen den Verbindungsflächen (5) von Gehäuseoberteil (3) und Gehäuseunterteil (4) erstrecken,
2. die Gehäuseteile (3,4) mit den dazwischenliegenden Zuführungsleitern (6) dadurch miteinander verbunden werden, daß die einzelnen, miteinander zu einem ringförmigen Leiter verbundenen Zuführungsleiter (6) in einem Hochfrequenzfeld erhitzt werden, bis die Gehäuseteile miteinander verbunden sind.

2. Verfahren nach Anspruch 1, dadurch gekennzeichnet,
daß die Zuführungsleiter (6) dadurch zu einem ringförmigen Leiter verbunden sind, daß nebeneinanderliegende, sich außerhalb des Gehäuses (1) erstreckende Enden (8) der Zuführungsleiter (6) miteinander verbunden sind.

3. Verfahren nach Anspruch 2, dadurch gekennzeichnet,
daß die Zuführungsleiter (6) als ein einstückiger ringförmiger Leiter hergestellt werden und die Verbindungen (9) der Enden (8) der Zuführungsleiter (6) nach dem Verschmelzen der Gehäuseteile (3,4) aufgetrennt werden.

4. Verfahren nach Anspruch 2, dadurch gekennzeichnet,
daß die nebeneinanderliegenden Enden (8) der einzelnen Zuführungsleiter (6) während des Erhitzens im Hochfrequenzfeld durch gesonderte Kontaktbrücken (10) miteinander verbunden werden.

5. Verfahren nach Anspruch 1, dadurch gekennzeichnet,
daß mindestens eine Verbindungsfläche (5) von dem Verbinden mit einem Verbindungsmaterial mit einem niedrigen Schmelzpunkt bedeckt wird.

6. Verfahren nach einem der Ansprüche 1 bis 4,
dadurch gekennzeichnet,
daß die außerhalb des Gehäuses (1) liegenden Enden (8) der Zuführungsleiter so geformt werden, daß sie zum Auflöten des Bauelementengehäuses (1) auf eine Leiterplatte geeignet sind.

7. Verfahren nach einem der Ansprüche 1 bis 4,
dadurch gekennzeichnet,
daß die außerhalb des Gehäuses (1) liegenden Enden (8) der Zuführungsleiter (6) so geformt werden, daß sie zum Einstecken in Bohrungen einer Leiterplatte geeignet sind.

8. Anwendung des Verfahrens nach einem der vorangehenden Ansprüche zum Herstellen eines Gehäuses für einen Schwingquarz.

## Claims

1. A method of manufacturing a hermetically sealed component housing which can be mounted directly on a printed circuit board, and which has a tray-like upper portion and a tray-like lower portion of a fusible insulating material, which portions are hermetically sealed to each other, the lead-in conductors connected to the component being accommodated in the junction between the upper and lower portions of the housing, characterized in that
a. the lead-in connected (6) connected to the component (2) are so formed that they partially extend in a longitudinal direction between the jointing surfaces (5) of upper portion (3) and lower portion (4) of the housing,
b. the housing portions (3,4) with the intermediate lead-in conductors 6 are interconnected by heating in a high frequency field the individual lead-in conductors (6) which are interconnected to form an annular conductor, until the housing portions are sealed together.

2. A method as claimed in Claim 1, characterized in that the lead-in conductors (6) are interconnected to form an annular conductor by interconnecting neighbouring ends (8) of the lead-in conductors (6) which extend outside the housing (1).

3. A method as claimed in Claim 2, characterized in that the lead-in conductors (6) are manufactured as annular conductors in one piece, and the connections (9) between the ends (8) of the lead-in conductors (6) are severed after fusion of the housing portions (3,4).

4. A method as claimed in Claim 2, characterized in that the neighbouring ends (8) of the individual lead-in conductors (6) are interconnected during heating in a high frequency field by individual connecting links (10).

5. A method as claimed in Claim 1, characterized in that, prior to connecting, at least one jointing surface (5) is coated with a low melting point connecting material.

6. A method as claimed in any one of the Claims 1 to 4, characterized in that the ends (8) of the lead-in conductors, which are situated outside the housing, are formed in such a way as to enable the component housing (1) to be soldered onto a printed circuit board.

7. A method as claimed in any one of the Claims 1 to 4, characterized in that the ends (8) of the lead-in conductors (6), which are situated outside the housing (1), are so formed that they are suitable for introduction into the bore holes of a printed circuit board.

8. The use of the method in accordance with any one of the preceding claims, for the manufacture of a housing for a quartz resonator.

## Revendications

1. Procédé de fabrication d'un boîtier de composant fermé hermétiquement qui convient pour le montage direct sur une plaque de circuit imprimé et qui comporte une partie de boîtier supérieure en forme de cuvette et une partie de boîtier inférieure en forme de cuvette réalisées en matériau isolant fusible reliées mutuellement de façon hermétique, les conducteurs qui s'étendent vers le composant étant incorporés dans le joint reliant la partie de boîtier supérieure à la partie de boîtier inférieure, caractérisé en ce que
1. les conducteurs (6) s'étendant vers le composant (2) sont conçus de manière qu'ils s'étendent partiellement suivant leur longueur entre les surfaces de contact (5) séparant les parties de boîtier supérieure (3) et inférieure (4),
2. les parties de boîtier (3, 4) et les conducteurs intercalés (6) sont mutuellement reliés du fait que les conducteurs individuels (6) reliés mutuellement de manière à constituer un seul conducteur annulaire sont chauffés dans un champ à haute fréquence jusqu'à ce que les parties de boîtier soient reliées l'une à l'autre.

2. Procédé selon la revendication 1, caractérisé en ce que les conducteurs (6) sont reliés de manière à constituer un seul conducteur annulaire du fait que des extrémités juxtaposées (8) des conducteurs (6) s'étendant à l'extérieure du boîtier 1 sont mutuellement reliées.

3. Procédé selon la revendication 2, caractérisé en ce que les conducteurs (6) sont fabriqués de manière à constituer un conducteur annulaire en une seule pièce et que les parties de connexion (9) reliant les extrémités (8) des conducteurs (6) sont découpées après la réunion par fusion des parties de boîtier (3, 4).

4. Procédé selon la revendication 2, caractérisé en ce que pendant le chauffage dans le champ à haute fréquence les extrémités juxtaposées (8) des conducteurs individuels (6) sont mutuellement reliées par des ponts de contact individuels (10).

5. Procédé selon la revendication 1, caractérisé en ce qu'avant la réunion au moins une face de contact (5) est couverte d'un matériau de liaison présentant un point de fusion bas.

6. Procédé selon les revendications 1 à 4, caractérisé en ce que les extrémités (8) des conducteurs s'étendant à l'extérieur du boîtier (1) sont formées de manière qu'elles conviennent à souder le boîtier de composant (1) sur une plaque de circuit imprimée.

7. Procédé selon les revendications 1 à 4, caractérisé en ce que les extrémités (8) des conducteurs (6) s'étendant à l'extérieur du boîtier (1) sont formées de manière qu'elles conviennent à être introduites dans des ouvertures percées dans une plaque de circuit imprimée.

8. Mise en oeuvre du procédé selon l'une des revendications précédentes pour fabriquer un boîtier destiné pour un cristal oscillateur.
